# FASCICULE DE BREVET EUROPEEN

(11) **EP 4 484 983 B1**
(45) Date de publication et mention de la délivrance du brevet: **14.10.2026**
(21) Numéro de dépôt: 24184113.9
(22) Date de dépôt: 24.06.2024
(51) Int. Cl.: G01R 31/392, G01R 31/367, G01R 31/389

(54) **PROCÉDÉ DE SURVEILLANCE D'UN ÉTAT DE SANTÉ D'UNE BATTERIE**
VERFAHREN ZUR ÜBERWACHUNG DES GESUNDHEITSZUSTANDS EINER BATTERIE
METHOD FOR MONITORING THE STATE OF HEALTH OF A BATTERY

(30) Priorité: 27.06.2023 FR 2306721
(43) Date de publication de la demande: 01.01.2025
(73) Titulaire: Safran Electrical & Power, 31702 Blagnac (FR); Université de Technologie de Compiègne, 60200 Compiègne (FR); Centre National de la Recherche Scientifique, 75016 Paris (FR)
(72) Inventeur: VENDRAME, Fernanda, 77550 Moissy-Cramayel (FR); DAMAY, Nicolas, 60200 Compiègne (FR); SAYEGH, Marie, 77550 Moissy-Cramayel (FR); FORGEZ, Christophe, 60200 Compiègne (FR)
(74) Mandataire: Cabinet Camus Lebkiri

(56) Documents cités:
- CN-A- 107 367 698
- CN-A- 115 032 540
- US-A1- 2019 041 464
- FABIAN SINGLE ET AL: "Theory of Impedance Spectroscopy for Lithium Batteries", ARXIV.ORG, CORNELL UNIVERSITY LIBRARY, 201 OLIN LIBRARY CORNELL UNIVERSITY ITHACA, NY 14853, 2 August 2019 (2019-08-02), XP081454494

## Description

### DOMAINE TECHNIQUE DE L'INVENTION

Le domaine technique de l'invention est celui de la surveillance et de la gestion des batteries électriques, en particulier des batteries embarquées dans un véhicule, notamment dans un aéronef.

La présente invention concerne un procédé de surveillance de l'état de santé d'une batterie.

### ARRIERE-PLAN TECHNOLOGIQUE DE L'INVENTION

Le changement climatique est une préoccupation majeure pour de nombreux organes législatifs et de régulation à travers le monde. En effet, diverses restrictions sur les émissions de carbone ont été, sont ou seront adoptées par divers Etats. En particulier, une norme ambitieuse s'applique à la fois aux nouveaux types d'avions mais aussi ceux actuellement en circulation nécessitant de devoir mettre en œuvre des solutions technologiques afin de les rendre conformes aux réglementations en vigueur. L'aviation civile se mobilise depuis maintenant plusieurs années pour apporter une contribution à la lutte contre le changement climatique.

Les efforts de recherche technologique ont déjà permis d'améliorer de manière très significative les performances environnementales des avions. La Déposante prend en considération les facteurs impactant toutes les phases de conception et de développement, pour obtenir des composants et des produits aéronautiques moins énergivores, plus respectueux de l'environnement et dont l'intégration et l'utilisation dans l'aviation civile ont des impacts environnementaux modérés dans un but d'amélioration de l'efficacité énergétique des avions. La Déposante travaille en permanence à la réduction de son impact climatique par l'emploi de méthodes et l'exploitation de procédés de développement et de fabrication vertueux et minimisant les émissions de gaz à effet de serre au minimum possible pour réduire de l'empreinte environnementale de son activité.

Ces travaux de recherche et de développement soutenus portent à la fois sur les nouvelles générations de moteurs d'avion, l'allègement des appareils, notamment par les matériaux employés et les équipements embarqués allégés, le développement de l'emploi des technologies électriques pour assurer la propulsion, et enfin les biocarburants aéronautiques.

Dans ce cadre, l'utilisation et la gestion des batteries électriques au sein des aéronefs doit être optimisée. L'état de santé d'une batterie, aussi couramment appelé SOH pour « State of Health » en anglais, peut être défini en fonction de la perte de capacité ou du gain de résistance d'une batterie tout au long de sa vie. Dans la présente demande, l'état de santé SOH est défini par :
$SOH = \frac{{C}_{actualle}}{{C}_{initiale}} \times 100 %$

Avec :
- *C_{actuelle}*, la capacité maximale actuelle de la batterie
- *Cᵢₙᵢₜᵢₐₗₑ*, la capacité maximale initiale de la batterie

En fonction de l'état de santé d'une batterie, l'utilisation de la batterie peut être modifiée. Par exemple, dans le secteur des transports, les batteries sont habituellement utilisées jusqu'à un état de santé seuil compris entre 70% et 80%. Cette première utilisation correspond à ce que l'on appelle la « première vie » d'une batterie. En dessous de cet état de santé seuil, la perte de capacité tend à s'accélérer, mais la batterie peut continuer à être utilisée dans des applications dites de « seconde vie », telles que les réseaux d'énergie de type « smart grid ».

Pour des applications embarquées, et notamment dans un aéronef, il est donc primordial de mesurer ou d'estimer l'état de santé d'une batterie. Des méthodes connues permettent de surveiller l'état de santé de la batterie sans nécessiter de démonter la batterie de l'appareil sur laquelle elle est embarquée. Par exemple, une première méthode, divulguée dans Maures, M., Capitaine, A., Delétage, J. Y., Vinassa, J. M., & Briat, O. (2020). Lithium-ion battery SoH estimation based on incremental capacity peak tracking at several current levels for online application. Microelectronics Reliability, 114, propose d'utiliser une méthode appelée « capacité incrémentale », dans laquelle la capacité chargée ou déchargée de la batterie est dérivée par rapport à la tension de la batterie. Ensuite, une analyse de la dérivée est effectuée pour identifier des pics afin d'en déterminer certaines caractéristiques corrélées avec l'état de santé de la batterie. Cette méthode a pour principal avantage d'être simple à implémenter. Toutefois, l'estimation de l'état de santé doit être effectuée dans des conditions précises. Ainsi, l'estimation de l'état de santé par cette méthode n'est possible que lors d'une charge à courant constant, passant par une plage de tension suffisamment large pour obtenir des pics dont les caractéristiques sont liées à l'état de santé de la batterie.

Une seconde méthode connue, divulguée dans Shen, P., Ouyang, M., Lu, L., Li, J., & Feng, X. (2018). The co-estimation of State of Charge, State of Health, and State of Function for lithium-ion batteries in electric vehicles. IEEE Transactions on Vehicular Technology, 67(1), 92-103, propose d'estimer l'état de santé d'une batterie en se basant sur une méthode des moindres carrés récursifs avec facteur d'oubli. Cette méthode est très complète car elle permet en outre d'estimer l'état de charge et l'état de fonctionnement de la batterie. Toutefois, cette méthode est complexe à implémenter.

Une troisième méthode connue, divulguée dans Zhou, Y., Huang, M., & Pecht, M. (2018, August 27). An Online State of Health Estimation Method for Lithium-ion Batteries Based on Integrated Voltage. 2018 IEEE International Conference on Prognostics and Health Management, ICPHM 2018, divulgue qu'il existe une corrélation linéaire entre l'état de santé d'une batterie et l'intégrale de la tension pendant une partie de la charge d'une batterie. Cette méthode est facile à implémenter, mais la validité de la relation entre l'état de santé d'une batterie et l'intégrale de la tension n'a été démontrée que pour le type de batterie présenté dans l'article. Ainsi, cette méthode ne peut, à l'heure actuelle, être utilisée pour des batteries de compositions chimiques différentes de celle présentée dans l'article. De plus, cette méthode nécessite de prendre en compte une plage d'états de charge de la batterie qui soit très large, ce qui n'est pas effectué systématiquement en fonction de l'application.

Les documents suivants sont aussi connus de l'art antérieur :
- le document CN 115 032 540 A intitulé « Lithium ion battery health state estimation method, device, equipment and medium »,
- le document intitulé « Theory of impedance spectroscopy for lithium batteries », Fabian Single et al, arxiv.org, Cornell university library, 201 Olin library Cornell university Ithaca, NY 14853, 2 août 2019 (2019-08-02), xp081454494,

le document CN 107 367 698 A intitulé « The health status Forecasting Methodology of electric automobile lithium battery group », et
le document US 2019/041464 A1 intitulé « Method and apparatus for identifying a battery model ».

Il existe donc un besoin de fournir une méthode de détermination d'un état de santé d'une batterie permettant de résoudre au moins partiellement les inconvénients des méthodes de l'art antérieur.

### RESUME DE L'INVENTION

L'invention est définie par la revendication indépendante de méthode 1, concernant un procédé de surveillance de l'état de santé d'une batterie électrique ; la revendication 6, relative à un système de gestion d'une batterie électrique configuré pour mettre en œuvre le procédé de l'invention défini dans les revendications de méthode ; la revendication 7, portant sur un aéronef comprenant une batterie et le système de gestion de batterie selon la revendication 6 ; et la revendication 8, relative à un programme d'ordinateur comprenant des instructions qui, lorsqu'elles sont exécutées par le système de gestion de batterie, mettent en œuvre le procédé de l'invention. En outre, la présente demande comprend les revendications dépendantes 2 à 5. L'invention offre une solution aux problèmes évoqués précédemment, en permettant de déterminer un état de santé SOH d'une batterie à partir de la résistance de surface R_{surf} de la batterie, de l'intensité I de courant appliqué à la batterie et de la température T de la batterie. En effet, les inventeurs ont, de manière surprenante, découvert qu'il était possible la résistance de surface R_{surf} de la batterie que les paramètres. Ainsi, l'invention comprend la génération d'un modèle de circuit électrique configuré pour évaluer un état de santé SOH d'une batterie, ledit modèle étant basé sur un modèle d'un composant d'un circuit électrique configuré pour évaluer une résistance de surface d'une batterie. Ensuite, en fournissant au modèle du composant du circuit électrique configuré pour évaluer un état de santé SOH d'une batterie, l'intensité I de courant appliqué à la batterie et de la température T de la batterie, il est possible d'obtenir l'état de santé SOH d'une batterie.

Un aspect de l'invention concerne un procédé de surveillance d'un état de santé SOH d'une batterie électrique comprenant les étapes suivantes :
- Obtention d'un premier modèle d'un composant d'un circuit électrique de la batterie, le premier modèle étant configuré pour évaluer une résistance de surface R_{surf} de la batterie à partir d'une intensité I de courant appliqué à la batterie et d'une température T de la batterie, le premier modèle comprenant en outre des paramètres, les paramètres comprenant :
   - Une résistance d'une interphase de l'électrolyte solide à une température prédéterminée notée R_{SEI} (Tₚᵣₑ),
   - Une énergie d'activation liée à l'interphase de l'électrolyte solide notée E_{a,SEI},
   - Un courant d'échange à une température prédéterminée noté I₀(Tₚᵣₑ), et
   - Une énergie d'activation liée au courant d'échange notée E_{a,I0},
- Détermination, pour chaque paramètre parmi les paramètres du premier modèle, d'une fonction caractérisant l'évolution dudit chaque paramètre en fonction d'une évolution de l'état de santé de la batterie SOH,
- Génération d'un second modèle du composant du circuit électrique de la batterie configuré pour évaluer l'état de santé de la batterie SOH à partir de la résistance de surface R_{surf} de la batterie, de l'intensité I de courant appliqué à la batterie et de la température T de la batterie, la génération du second modèle comprenant pour chaque paramètre du premier modèle, l'intégration de la fonction caractérisant l'évolution dudit chaque paramètre en fonction d'une évolution de l'état de santé de la batterie SOH,
- Mesure de l'intensité I de courant appliqué à la batterie, de la température T de la batterie et obtention de la résistance de surface Rsurf de la batterie, et
- Détermination de l'état de santé de la batterie SOH en fournissant au second modèle l'intensité I de courant appliqué à la batterie, la température T de la batterie et la résistance de surface Rsurf de la batterie obtenus.

Grâce à l'invention, la surveillance de l'état de santé de la batterie peut être effectuée facilement et directement dans un système embarqué. En effet, le procédé selon l'invention peut être appliqué à n'importe quelle condition opérationnelle en termes de courant et température et ne demande pas de balayer une large plage d'état de charge. Par ailleurs, le procédé selon l'invention ne nécessite pas l'utilisation d'un composant « observateur » en continu. Il peut être appliqué de manière discontinue, par exemple à des moments où la mise à jour de l'état de santé de la batterie est nécessaire. Par exemple, le procédé selon l'invention peut être mis en œuvre durant la charge de la batterie. En effet, la charge de la batterie est un moment opportun pour mettre en œuvre le procédé selon l'invention, car il est possible, durant la charge de batterie, d'appliquer un créneau de courant constant à partir duquel il est possible d'obtenir la résistance de surface.

Outre les caractéristiques qui viennent d'être évoquées dans le paragraphe précédent, le procédé de surveillance selon un aspect de l'invention peut présenter une ou plusieurs caractéristiques complémentaires parmi les suivantes, considérées individuellement ou selon toutes les combinaisons techniquement possibles :
- le premier modèle du composant du circuit électrique de la batterie est basé sur l'équation suivante : $\begin{matrix}{R}_{surf} \left(I, T\right) = {R}_{SEI} \left(25°C\right) exp \left(\frac{{E}_{a , SEI}}{{k}_{B}}\left(\frac{1}{T}-\frac{1}{298}\right)\right) \\ + \frac{2 RT}{FI} asinh \left(\frac{I}{2 {I}_{0} \left(25°C\right)}exp\left(\frac{{E}_{a , {I}_{0}}}{{k}_{B}}\left(\frac{1}{T}-\frac{1}{298}\right)\right)\right)\end{matrix}$
   Avec:
   - *R_{SEI}*(25°*C*), une résistance d'une interphase de l'électrolyte solide à une température de 25°C, exprimée en ohms noté Ω,
   - *E_{a,SEI}*, une énergie d'activation liée à l'interphase de l'électrolyte solide, exprimée en électronvolts noté eV,
   - *I*₀(25°*C*), une intensité d'un courant d'échange de la batterie à 25°C, exprimée en ampères noté A,
   - *E*_{*a,I*₀}, une énergie d'activation liée à l'intensité d'un courant d'échange de la batterie à 25°C, exprimée en électronvolts noté eV,
   - *k_{B},* une constante de Boltzmann, exprimée en électronvolts par kelvin noté eV/K,
   - R, une constante universelle des gaz parfaits, exprimée en joules par mole par kelvin noté J/(mol*K),
   - F, une constante de Faraday, exprimée en coulombs par mole noté C/mol,
   - *T* , une température de la batterie, exprimée en kelvin noté K,
   - *I*, une intensité du courant de la cellule, exprimé en ampères noté A.
- Le procédé selon l'invention comprend en outre une modification des conditions d'utilisation de la batterie en fonction de l'état de santé SOH déterminé.
- La modification des conditions d'utilisation de la batterie en fonction de l'état de santé SOH déterminé comprend :
   - Lorsque l'état de santé SOH déterminé est inférieur à une valeur seuil d'état de santé prédéterminée, remplacer la batterie par une nouvelle batterie, et/ou
   - Interrompre une utilisation de la batterie en cas d'atteinte d'une température maximale, la température maximale étant déterminée à partir de l'état de santé SOH déterminé, et/ou
   - Charger la batterie à une intensité de courant inférieure ou égale à une intensité de courant maximale, l'intensité de courant maximale étant déterminée à partir de l'état de santé SOH déterminé.
- la détermination, pour chaque paramètre parmi les paramètres du premier modèle, d'une fonction caractérisant l'évolution dudit chaque paramètre en fonction d'une évolution de l'état de santé de la batterie SOH comprend :
   - un premier essai de spectroscopie d'impédance électrochimique consistant à appliquer à la batterie une onde de courant sinusoïdale avec une valeur moyenne nulle à la batterie et à mesurer une variation de tension de la batterie, et/ou
   - un second essai d'impulsions de courant consistant à appliquer à la batterie des impulsions de courant en charge et en décharge.
- la génération du second modèle du composant du circuit électrique de la batterie comprend une détermination d'une équation entre la résistance de surface R_{surf} et l'état de santé SOH et :
   - Une résolution de l'équation, pour un ensemble de valeurs de SOH, permettant d'évaluer l'état de santé SOH à partir de la résistance de surface R_{surf} de la batterie, ou
   - Une génération d'une table des paramètres permettant d'évaluer directement l'état de santé SOH à partir de l'intensité I de courant appliqué à la batterie, de la température T de la batterie et de la résistance de surface R_{surf} de la batterie.

Un second aspect de l'invention concerne un procédé de détermination d'une résistance de surface R_{surf} d'une batterie électrique comprenant les étapes :
- Obtention d'un premier modèle d'un composant d'un circuit électrique de la batterie, le premier modèle étant configuré pour évaluer une résistance de surface R_{surf} de la batterie à partir d'une intensité I de courant appliqué à la batterie et d'une température T de la batterie, le premier modèle comprenant en outre des paramètres, les paramètres comprenant :
   - Une résistance d'une interphase de l'électrolyte solide à une température prédéterminée notée R_{SEI} (Tₚᵣₑ),
   - Une énergie d'activation liée à l'interphase de l'électrolyte solide notée E_{a,SEI},
   - Un courant d'échange à une température prédéterminée noté I₀(Tₚᵣₑ), et
   - Une énergie d'activation liée au courant d'échange notée E_{a,I0},
- Détermination, pour chaque paramètre parmi les paramètres du premier modèle, d'une fonction caractérisant l'évolution dudit chaque paramètre en fonction d'une évolution de l'état de santé de la batterie SOH,
- Génération d'un second modèle du composant du circuit électrique de la batterie configuré pour évaluer la résistance de surface R_{surf} de la batterie à partir de l'intensité I de courant appliqué à la batterie, de la température T de la batterie et de l'état de santé de la batterie SOH, la génération du second modèle comprenant pour chaque paramètre du premier modèle, l'intégration de la fonction caractérisant l'évolution dudit chaque paramètre en fonction d'une évolution de l'état de santé de la batterie SOH,
- Mesure de l'intensité I de courant appliqué à la batterie, de la température T de la batterie et obtention de l'état de santé SOH de la batterie, et
- Détermination de la résistance de surface R_{surf} d'une batterie en fournissant au second modèle l'intensité I de courant appliqué à la batterie, la température T de la batterie et l'état de santé SOH de la batterie mesurés ou obtenus.

Un troisième aspect de l'invention concerne un système de gestion d'une batterie électrique comprenant des moyens de mise en œuvre du procédé selon l'invention.

Un quatrième aspect de l'invention concerne un aéronef comprenant une batterie électrique et un système de gestion de la batterie selon l'invention.

Un cinquième aspect de l'invention concerne un programme d'ordinateur comprenant des instructions qui, lorsque le programme est exécuté par un ordinateur, conduisent celui-ci à mettre en œuvre un procédé selon l'invention.

Un sixième aspect de l'invention concerne un support de données lisible par ordinateur, sur lequel est enregistré le programme d'ordinateur selon l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre un schéma synoptique d'un exemple de procédé de surveillance d'un état de santé SOH d'une batterie selon l'invention.
- La figure 2 montre un schéma synoptique d'un exemple de procédé de surveillance d'une résistance de surface R_{surf} d'une batterie selon l'invention.
- La figure 3A, la figure 3B, la figure 3C et la figure 3D montrent un exemple de relation entre chacun des paramètres du premier modèle et l'état de santé de la batterie SOH.
- La figure 4 montre un exemple d'un résultat d'un essai de spectroscopie d'impédance électrochimique effectué sur une batterie.
- La figure 5 montre un exemple d'un résultat d'un essai d'impulsions de courant effectué sur une batterie.
- La figure 6 montre un exemple d'une représentation schématique d'un circuit électrique.
- La [Fig. 7] montre un exemple de déduction de l'état de santé SOH d'une batterie à partir de la résistance de surface *Rsurf* pour une intensité I de batterie de 2 A et une température T de batterie de 0°C.
- La figure 8 montre un exemple d'évolution de la résistance de surface *Rsurf* en fonction de l'état de santé SOH d'une batterie pour une température T de batterie de 0°C et pour des intensités I de courant comprises entre 0 et 20 ampères en décharge.
- La figure 9 montre un exemple d'évolution de la résistance de surface *Rsurf* en fonction de l'état de santé SOH d'une batterie pour une intensité de courant fixe de 2 ampères en décharge pour des températures entre - 10 et 40°C.

### DESCRIPTION DETAILLEE

Les figures sont présentées à titre indicatif et nullement limitatif de l'invention.

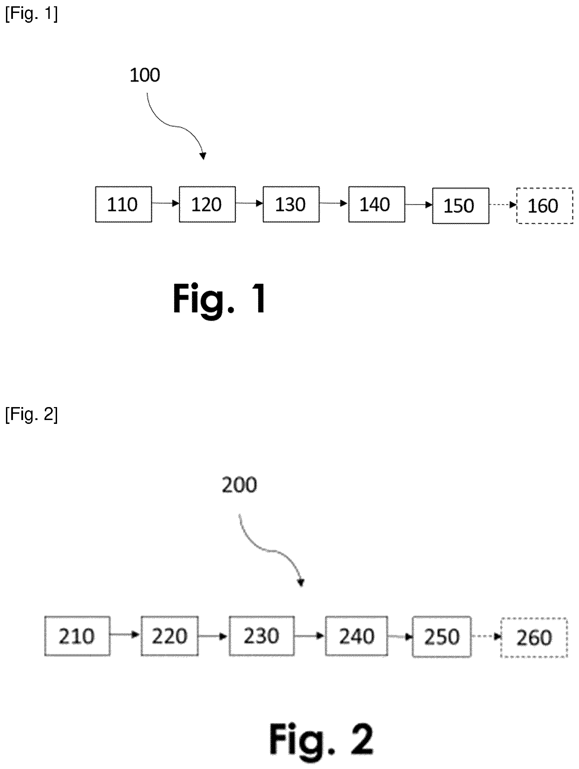

La figure 1 est un schéma synoptique illustrant les étapes d'un exemple du procédé 100 de surveillance d'un état de santé SOH d'une batterie. Les étapes obligatoires de l'exemple du procédé 100 sont indiquées par un rectangle en traits pleins et les étapes facultatives sont indiquées par un rectangle en traits pointillés.

Le procédé 100 de surveillance peut être mis en œuvre par ordinateur ou par un processeur. Par exemple, le procédé 100 de commande peut être mis en œuvre par un processeur compris dans un système de management d'une batterie d'un système embarqué tel qu'un aéronef. Le système de management a de préférence la structure d'un calculateur (en l'occurrence un calculateur de bord), et/ou d'un ordinateur. Il comprend un circuit électronique (en une ou plusieurs parties) équipé au moins d'une mémoire de type non-volatile, et d'un processeur permettant d'exécuter des opérations logiques. Il peut comprendre aussi une ou plusieurs autres mémoires, de type mémoire vive (RAM) ou d'un autre type, et un ou plusieurs autres processeurs.

Par « mis en œuvre par ordinateur », on entend que les étapes, ou pratiquement toutes les étapes, sont exécutées par au moins un ordinateur ou processeur ou tout autre système similaire. Ainsi, des étapes sont réalisées par le calculateur, éventuellement de manière entièrement automatique, ou semi-automatique. Dans des exemples, le déclenchement d'au moins certaines des étapes du procédé peut être effectué par interaction utilisateur-ordinateur. Le niveau d'interaction utilisateur-ordinateur requis peut dépendre du niveau d'automatisme prévu et mis en balance avec la nécessité de mettre en œuvre les souhaits de l'utilisateur. Dans des exemples, ce niveau peut être défini par l'utilisateur et/ou prédéfini.

Un exemple typique de mise en œuvre par ordinateur d'un procédé consiste à exécuter le procédé avec un système adapté à cet effet. Le système peut comprendre un processeur couplé à une mémoire et une interface utilisateur graphique (GUI), un programme informatique comprenant des instructions pour mettre en œuvre le procédé étant enregistré dans la mémoire. La mémoire peut également stocker une base de données. La mémoire est tout matériel adapté pour un tel stockage, comprenant éventuellement plusieurs parties physiques distinctes.

Une première étape 110 du procédé 100 consiste à obtenir un premier modèle d'un composant d'un circuit électrique de la batterie. Ce premier modèle permet de calculer une résistance de surface R_{surf} de la batterie à partir d'une intensité I de courant appliqué à la batterie et d'une température T de la batterie. L'intensité I de courant appliqué à la batterie est exprimé en Ampères. La température T de la batterie est exprimée en Kelvin. Ce premier modèle comprend en outre quatre paramètres.

Le premier paramètre du premier modèle du composant du circuit électrique de la batterie est la résistance d'une interphase de l'électrolyte solide à une température prédéterminée notée R_{SEI} (Tₚᵣₑ). L'interphase de l'électrolyte solide, couramment appelée « Solid Electrolyte Interphase » en anglais, est une couche de passivation présente entre l'électrode négative et l'électrolyte de la batterie. La résistance de l'interphase de l'électrolyte solide R_{SEI} est exprimée en ohms. De manière préférentielle, la température prédéterminée est comprise entre 0°C et 30°C. Dans la suite de la demande, par souci de simplification, nous utiliserons 25°C comme température prédéterminée. Il est possible de noter que le premier modèle du composant du circuit électrique est d'autant plus précis que la température T de la batterie est proche de ladite température prédéterminée.

Le second paramètre du premier modèle du composant du circuit électrique de la batterie est l'énergie d'activation liée à l'interphase de l'électrolyte solide notée E_{a,SEI}. L'énergie d'activation liée à l'interphase de l'électrolyte solide E_{a,SEI} est exprimée en électronvolts.

Le troisième paramètre du premier modèle du composant du circuit électrique de la batterie est le courant d'échange à la température prédéterminée noté I₀(Tₚᵣₑ). Ce paramètre est exprimé en ampères. Ce paramètre permet de mesurer le niveau de réactions d'oxydation et de réduction ayant lieu dans la batterie pour la température prédéterminée. Ainsi, un courant d'échange élevé reflète un niveau de réactions d'oxydation et de réduction dans la batterie lui aussi élevé donc un transfert de charge efficace. La température prédéterminée du troisième paramètre est la même que pour le premier paramètre.

Le quatrième paramètre du premier modèle du composant du circuit électrique de la batterie est l'énergie d'activation liée au courant d'échange E_{a,I0} qui est exprimée en électronvolts.

Dans une variante de l'invention, le premier modèle du composant du circuit électrique de la batterie est basé sur l'équation suivante : ${R}_{surf} \left(I, T\right) = {R}_{SEI} \left(25°C\right) exp \left(\frac{{E}_{a , SEI}}{{k}_{B}}\left(\frac{1}{T}-\frac{1}{298}\right)\right) + \frac{2 RT}{FI} asinh \left(\frac{I}{2 {I}_{0} \left(25°C\right)}exp\left(\frac{{E}_{a , {I}_{0}}}{{k}_{B}}\left(\frac{1}{T}-\frac{1}{298}\right)\right)\right)$ (1)
Avec :
- *R_{SEI}*(25°*C*), une résistance d'une interphase de l'électrolyte solide d'une batterie à une température de 25°C, exprimée en ohms noté Ω,
- *E_{a,SEI}*, une énergie d'activation liée à l'interphase de l'électrolyte solide d'une batterie, exprimée en électronvolts noté eV,
- *I*₀(25°*C*), une intensité d'un courant d'échange de la batterie à 25°C liée au transfert de charge de la batterie, exprimée en ampères noté A,
- *E*_{*a,I*₀}, une énergie d'activation liée à l'intensité d'un courant d'échange de la batterie à 25°C, et donc aussi liée au transfert de charge de la batterie, exprimée en électronvolts noté eV,
- *k_{B},* la constante de Boltzmann, exprimée en électronvolts par kelvin noté eV/K,
- *R,* la constante universelle des gaz parfaits, exprimée en joules par mole par kelvin noté J/(mol*K),
- *F,* la constante de Faraday, exprimée en coulombs par mole noté C/mol,
- *T* , une température de la batterie, exprimée en kelvin noté K,
- *I*, une intensité du courant de la cellule, exprimée en ampères noté A.

Cette équation est divulguée dans Damay N., Mbeya K. M., Friedrich G., and Forgez C., "Separation of the charge transfers and solid electrolyte interphase contributions to a battery voltage by modeling their non-linearities regarding current and temperature," Journal of Power Sources, vol. 516, p. 230617, 12 2021. Elle modélise la résistance de surface d'une batterie en fonction d'une intensité de la batterie et de la température de la batterie.

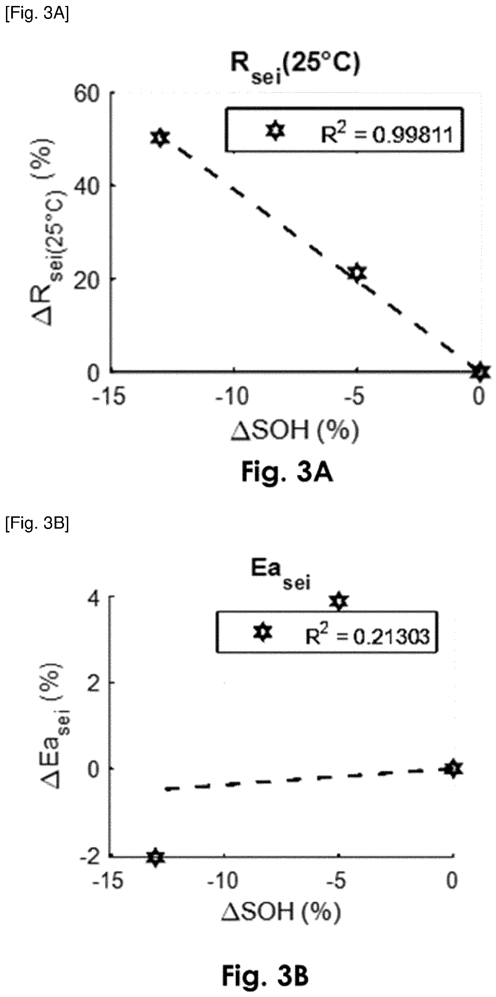

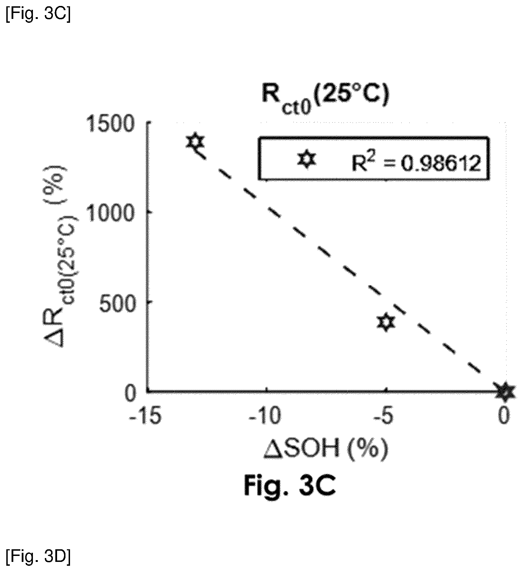

Une seconde étape 120 du procédé 100 consiste à déterminer, pour les quatre paramètres du premier modèle, une fonction caractérisant l'évolution dudit chaque paramètre en fonction d'une évolution de l'état de santé de la batterie SOH. Les figures 3A à 3D montrent un exemple d'évolution pour chaque paramètre du premier modèle électrique en fonction de l'état de santé SOH de la batterie. La figure 3A montre un exemple de relation entre la résistance de l'interphase de l'électrolyte solide d'une batterie à une température de 25°C *R_{SEI}*(25°*C*) et l'état de santé de la batterie *SOH.* La figure 3B montre un exemple de relation entre l'énergie d'activation liée à l'interphase de l'électrolyte solide d'une batterie *E_{a,SEI}* et l'état de santé de la batterie *SOH.* La figure 3C montre un exemple de relation entre la résistance de transfert de charge à courant nul d'une batterie notée *R*_{*ct*,0}(*T*) et l'état de santé de la batterie *SOH.* La figure 3D montre un exemple de relation entre l'énergie d'activation liée à l'intensité d'un courant d'échange de la batterie à 25°C *E*_{*a,I*₀} et l'état de santé de la batterie *SOH.* Concernant la figure 3C, il faut noter qu'il est possible d'obtenir l'intensité d'un courant d'échange de la batterie à 25°C à partir de la résistance de transfert de charge à courant nul d'une batterie *R*_{*ct,*0}(*T*)*.* Par exemple, il est possible de se baser sur l'équation suivante :
${R}_{ct , 0} \left(T\right) = \frac{RT}{{FI}_{0} \left(T\right)}$ (2)

Avec :
- *R,* la constante universelle des gaz parfaits, exprimée en joules par mole par kelvin noté J/(mol*K),
- *T* , une température de la batterie, exprimée en kelvin noté K, et
- *F,* la constante de Faraday, exprimée en coulombs par mole noté C/mol.

Les inventeurs ont donc montré que chacun des paramètres pouvait être modélisé en fonction de l'état de santé de la batterie avec une fonction. Dans cet exemple, une fonction de forme linéaire peut être utilisée. Ainsi, sur chacune des figures 3A à 3D, le carré du coefficient de corrélation linéaire noté R² est indiqué. Par exemple, le carré du coefficient de corrélation linéaire R² pour la figure 3A est de 0.99811. Pour un autre type de cellule, il est possible que ces paramètres varient différemment en fonction de l'état de santé SOH de la batterie : de façon quadratique par exemple.

Dans un exemple, compatible avec la variante de l'invention, la détermination 120, pour chaque paramètre du premier modèle, d'une fonction caractérisant l'évolution dudit chaque paramètre en fonction d'une évolution de l'état de santé de la batterie SOH comprend deux essais.

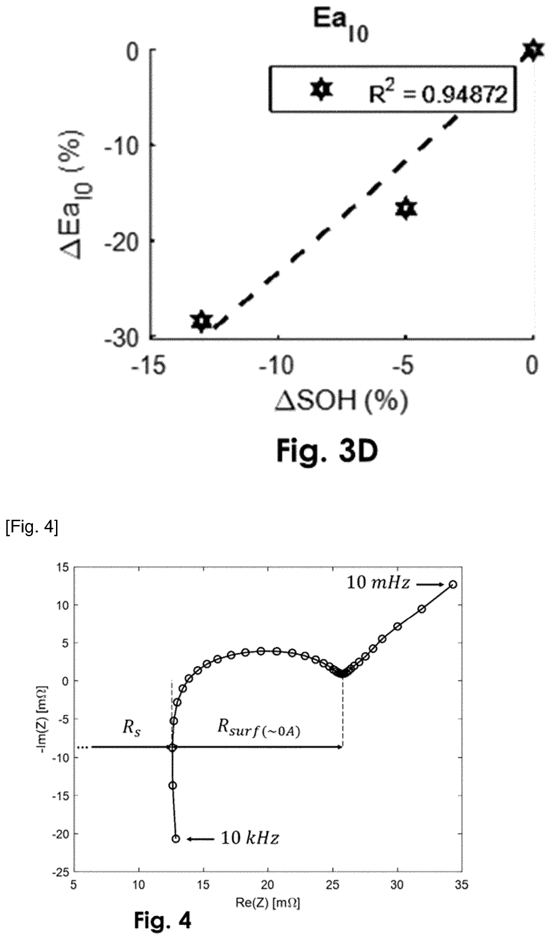

Le premier essai est un essai de spectroscopie d'impédance électrochimique. L'essai de spectroscopie d'impédance électrochimique consiste à appliquer à la batterie une onde de courant sinusoïdale avec une valeur moyenne nulle et à mesurer une variation de tension de la batterie. A partir de cet essai, il est possible d'identifier une résistance en série *Rs,* qui est indépendante du courant, ainsi que la résistance de surface *Rsurf* de la batterie pour un courant quasi-nul, i.e. la moyenne du courant sinusoïdale est nulle ou quasi nulle. La résistance en série *Rs* représente toutes les contributions purement résistives, telles que l'électrolyte, les collecteurs de courant et les résistances de contact de la batterie. Un exemple d'un résultat d'un essai de spectroscopie d'impédance électrochimique est illustré à la figure 4. La figure 4 a pour axe en abscisses la composante réelle de l'impédance exprimée en milliohms, et pour axe en ordonnées la composante imaginaire, en négatif, de l'impédance exprimée en milliohms.

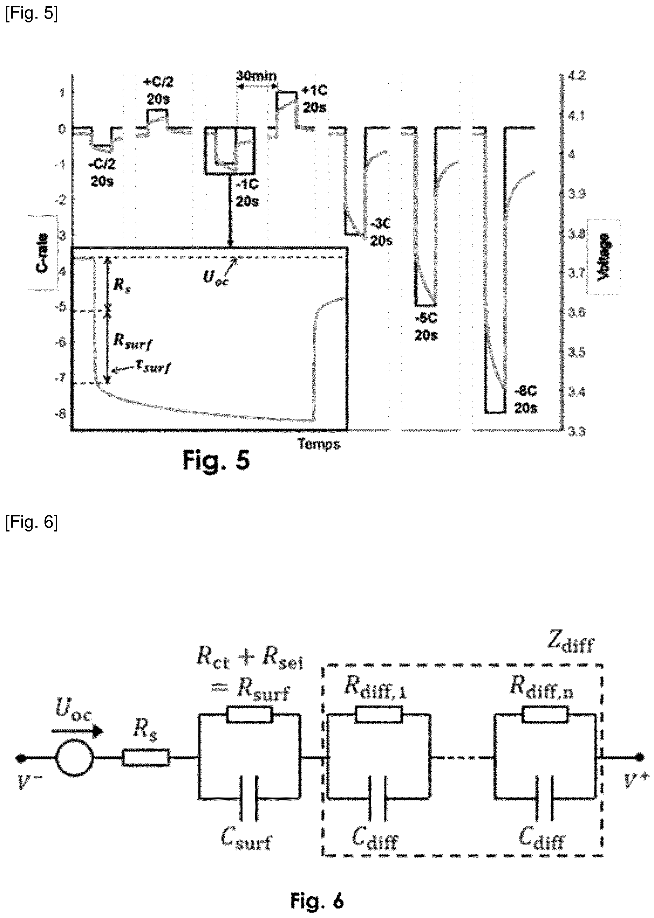

Le second essai est un essai d'impulsions de courant consistant à appliquer à la batterie des impulsions de courant en charge et en décharge. Cet essai permet d'extraire des informations sur l'impédance de la batterie en analysant sa réponse en tension. A partir de cet essai, on identifie une tension de la cellule à l'équilibre U_{oc}, la résistance de surface R_{surf} de la batterie pour des courants différents de zéro, une constante de temps liée aux phénomènes de surface notée T_{surf} et une impédance notée Z_{diff}. La tension de la cellule à l'équilibre U_{oc} est une source de tension représentant la tension de circuit ouvert, couramment notée OCV pour l'anglais « Open-Circuit Voltage ». La résistance de surface R_{surf} est liée à la chute de tension entre la surface du matériau actif et l'électrolyte, due au transfert de charge et à l'interphase de l'électrolyte. La constante de temps liée aux phénomènes de surface T_{surf} est égale au produit entre la résistance de surface R_{surf} et la capacité de surface, appelée aussi capacité de double couche C_{surf}. Cette constante de temps est liée aux phénomènes de surface qui sont associés au transfert de charge, aux doubles couches et à l'interphase de l'électrolyte. Cette constante de temps liée aux phénomènes de surface T_{surf} représente une dynamique rapide, généralement inférieure à 1 seconde. L'impédance Z_{diff} est une impédance liée aux phénomènes de diffusion des ions lithium dans l'électrolyte et des atomes de lithium dans les deux électrodes. Cette impédance a une dynamique lente, généralement de l'ordre de plusieurs minutes. Un exemple d'un résultat d'un essai d'impulsions de courant est illustré à la figure 5. La figure 5 a pour axe en abscisses le temps exprimé en secondes. Pour une lecture plus claire, une partie de l'axe en abscisses est masqué ; ainsi, certaines durées sont indiquées en secondes (noté s) et d'autres en minutes (noté min). L'axe en ordonnées situé sur la gauche correspond au niveau de courant de la batterie, exprimé en C-rate c'est-à-dire un courant de charge et/ou décharge en ampères (A) divisé par la capacité en ampère-heure (Ah). L'axe en ordonnées situé sur la droite correspond à la tension de la batterie exprimée en volts.

Ainsi ces essais permettent d'identifier l'ensemble des paramètres d'une représentation schématique d'un circuit électrique tel qu'illustré à la figure 6. Pour identifier les paramètres *R_{SEI}*(*Tpre*), *E_{a,SEI}*, *I*₀(*Tpre*) et *E*_{*a,I*₀}, il est possible d'utiliser un algorithme d'optimisation permettant d'ajuster une équation aux valeurs de R_{surf} identifiées à partir des essais spectroscopie d'impédance électrochimique et d'impulsions de courant.

Une troisième étape 130 du procédé 100 consiste à générer un second modèle du composant du circuit électrique de la batterie. Ce second modèle est configuré pour évaluer l'état de santé de la batterie SOH à partir de la résistance de surface R_{surf} de la batterie, de l'intensité I de courant appliqué à la batterie et de la température T de la batterie. Afin de générer ce second modèle du composant du circuit électrique, chaque fonction caractérisant l'évolution de chacun des quatre paramètres du premier modèle en fonction d'une évolution de l'état de santé de la batterie SOH est intégrée dans le second modèle. Par exemple, dans la variante de l'invention, il est possible d'intégrer dans l'équation (1), la fonction caractérisant l'évolution de chacun des quatre paramètres du premier modèle en fonction d'une évolution de l'état de santé de la batterie SOH est intégrée dans le second modèle pour obtenir : $\begin{matrix}{R}_{surf} \left(I, T, SOH\right) = {R}_{SEI , neuf} \left(25°C\right) \left[{α}_{{R}_{SEI}}\left(SOH-1\right)+1\right] \times exp \left(\frac{{E}_{a , SEI}}{{k}_{B}}\left(\frac{1}{T}-\frac{1}{298}\right)\right) + \\ \frac{2 RT}{FI} asinh \left(\frac{I}{2 {I}_{0 , neuf} \left(25°C\right)}\left[{α}_{{R}_{ct}}\left(SOH-1\right)+1\right]exp\left(\frac{{E}_{a , {I}_{0} , neuf} \left[{α}_{{E}_{a , {I}_{0}}}\left(SOH-1\right)+1\right]}{{k}_{B}}\left(\frac{1}{T}-\frac{1}{298}\right)\right)\right)\end{matrix}$ (3)

Comme illustré à la figure 3B, l'énergie d'activation liée à l'interphase de l'électrolyte solide *E_{a,SEI}* d'une batterie varie peu en fonction de l'état de santé SOH de la batterie. Ainsi, dans l'équation (3), l'intégration de ce paramètre *E_{a,SEI}* n'a pas été effectuée. Toutefois, il faut noter que pour un autre type de batterie, l'énergie d'activation liée à l'interphase de l'électrolyte solide *E_{a,SEI}* pourrait varier de manière significative. La variation des trois autres paramètres est quasi linéaire, ainsi la relation suivante a été utilisée pour ces trois paramètres dans l'équation (3) :
${X}_{actuel} = {X}_{neuf} \left({α}_{X}\left(SOH-1\right)+1\right)$ (4)

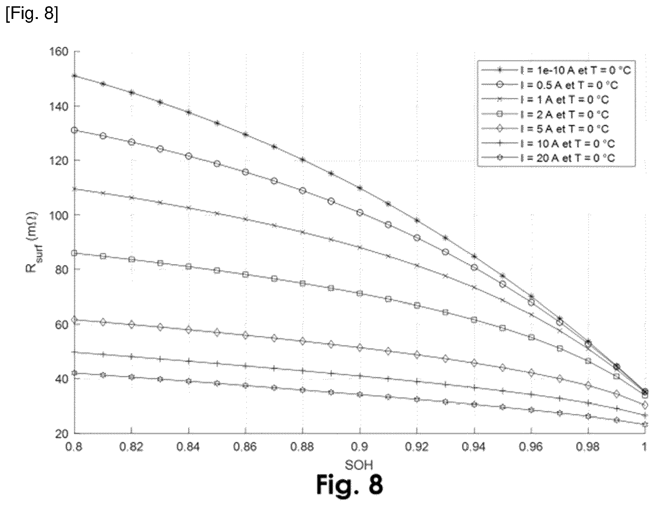

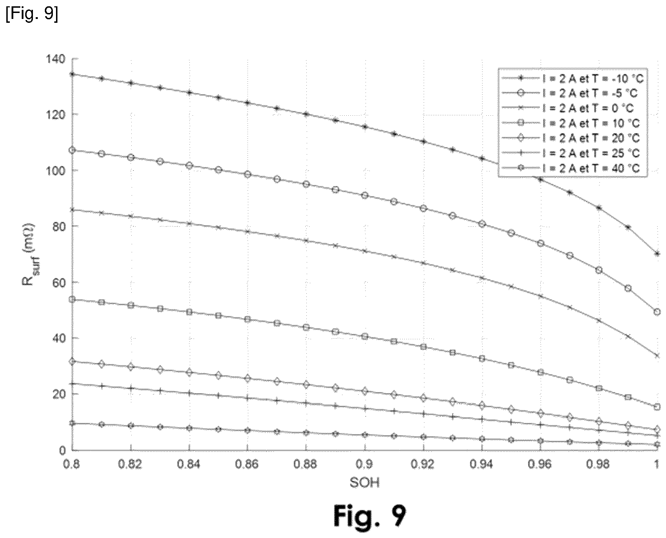

Dans un exemple, compatible avec les exemples précédents, la génération 130 du second modèle du composant du circuit électrique de la batterie comprend en outre une détermination d'une équation entre la résistance de surface R_{surf} et l'état de santé SOH. Ensuite, deux options sont possibles. La première option consiste à résoudre cette équation pour un ensemble de valeurs de SOH, permettant ainsi d'évaluer l'état de santé SOH à partir d'une résistance de surface R_{surf}. Par exemple, la figure 8 montre un exemple d'évolution de la résistance de surface R_{surf} en fonction de l'état de santé SOH d'une batterie pour une température T de batterie de 0°C et pour des intensités I de courants entre 0 et 20 ampères en décharge. De même, la figure 9 montre un exemple d'évolution de la résistance de surface R_{surf} en fonction de l'état de santé SOH d'une batterie pour une intensité de courant de 2 ampères en décharge pour des températures entre -10 et 40°C. Alternativement à la résolution de cette équation, la seconde option consiste à générer une table des paramètres permettant d'évaluer directement l'état de santé SOH à partir de l'intensité I de courant appliqué à la batterie, de la température T de la batterie et de la résistance de surface R_{surf} de la batterie.

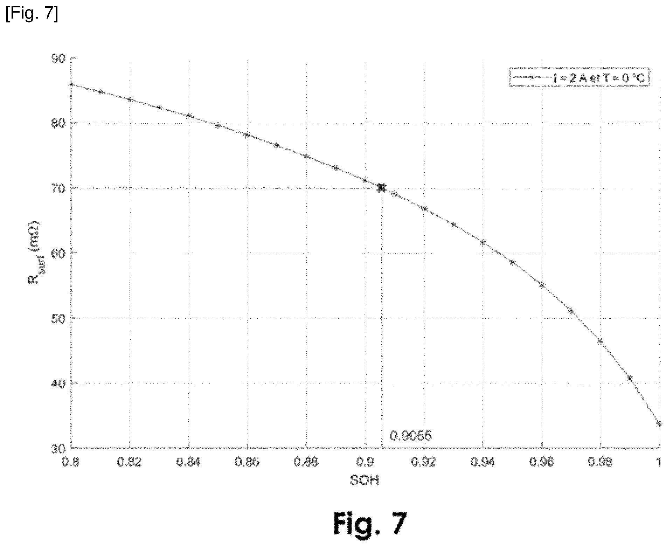

Cet exemple, quel que soit l'option choisie, permet ainsi d'utiliser un second modèle du composant du circuit électrique se basant sur une équation telle que l'équation (3). En effet, cette équation ne peut être inversée. Ainsi, l'état de santé SOH ne peut être exprimé directement en fonction de l'intensité I de courant appliqué à la batterie, de la température T de la batterie et de la résistance de surface R_{surf} de la batterie. Dans ce cas, il est nécessaire de résoudre l'équation de la résistance de surface *Rsurf* pour l'intensité de courant I et la température T mesurés de sorte à obtenir une équation de la résistance de surface *Rsurf* en fonction de l'état de santé *SOH* uniquement. Selon la première option, cette équation simplifiée peut être résolue pour un certain nombre d'états de santé SOH, créant ainsi une table d'états de santé SOH en fonction de la résistance de surface *Rsurf,* pour ensuite interpoler la valeur de résistance de surface *Rsurf* déjà connue et obtenir l'état de santé SOH recherché. Cette démarche est par exemple illustrée sur la figure 7. Ainsi, la figure 7 illustre la courbe correspondant à *Rsurf = f(2 A,* 0°*C, SOH),* c'est-à-dire la résistance de surface R_{surf} d'une batterie pour un courant mesuré de 2 ampères et une température mesurée de 0°C. Ainsi, pour une résistance de surface *Rsurf* de 70 mΩ identifiée par exemple à l'aide d'algorithmes embarqués, une interpolation de la courbe *Rsurf = f*(2 *A*, 0°*C*, *SOH)* permet d'évaluer l'état de santé SOH de la batterie à 0.9055. Cela signifie que la capacité actuelle de la batterie est égale à 90.55% de sa capacité initiale, i.e. à l'état neuf. Selon la seconde option, il est également envisageable d'utiliser l'équation *Rsurf = f*(*I,T,SOH*) pour générer une table de paramètres qui peut être stockée dans le système embarqué. Cette table permet d'interpoler directement les valeurs mesurées de I et de T et la valeur estimée du SOH, au lieu de résoudre l'équation pour I et T. Le choix d'implémenter la première ou la seconde option peut dépendre de la capacité de calcul du système et de sa capacité de stockage. Ainsi, pour un système principalement limité en capacité de calcul du système, la seconde option est la plus adaptée alors que pour système principalement limité en capacité de stockage, la première option est à privilégier.

Une quatrième étape 140 du procédé 100 consiste à mesurer l'intensité I de courant appliqué à la batterie, la température T de la batterie et obtenir la résistance de surface R_{surf} de la batterie. Pour obtenir, la résistance de surface *Rsurf* de la batterie, il est possible d'utiliser une technique connue de l'état de l'art pouvant être implémentée via des algorithmes embarqués. Cette étape 140 peut s'effectuer pendant l'utilisation de la batterie, notamment durant la charge de la batterie.

Une cinquième étape 150 du procédé 100 consiste à déterminer l'état de santé de la batterie SOH en fournissant au second modèle du composant du circuit électrique de la batterie l'intensité I de courant appliqué à la batterie, la température T de la batterie et la résistance de surface R_{surf} de la batterie mesurés ou obtenus à l'étape 140.

Dans un exemple, compatible avec les exemples précédents, une sixième étape optionnelle 160 du procédé 100 consiste à modifier les conditions d'utilisation de la batterie en fonction de l'état de santé SOH déterminé à l'étape 150. Par exemple, lorsque l'état de santé SOH déterminé est inférieur à une valeur d'état de santé SOH prédéterminée par exemple 70 ou 80%, la modification des conditions d'utilisation de la batterie peut consister à remplacer la batterie par une nouvelle batterie. La batterie dont l'état de santé SOH déterminé est inférieur à une valeur d'état de santé SOH prédéterminée peut par exemple être utilisée dans des applications dites de seconde vie. Dans un second exemple, la modification des conditions d'utilisation de la batterie peut consister à interrompre une utilisation de la batterie en cas d'atteinte d'une température maximale, la température maximale étant déterminée à partir de l'état de santé SOH déterminé. Dans un troisième exemple, la modification des conditions d'utilisation de la batterie peut consister à charger la batterie à une intensité de courant inférieure ou égale à une intensité de courant maximale, l'intensité de courant maximale étant déterminée à partir de l'état de santé SOH déterminé.

Un autre aspect de l'invention concerne un procédé 200 de détermination d'une résistance de surface R_{surf} d'une batterie. La figure 2 est un schéma synoptique illustrant les étapes d'un exemple du procédé 200. Les étapes obligatoires de l'exemple du procédé 200 sont indiquées par un rectangle en traits pleins et les étapes facultatives sont indiquées par un rectangle en traits pointillés.

Une première étape 210 et une seconde étape 220 du procédé 200 sont de préférence identiques respectivement aux étapes 110 et 120 du procédé 100.

Une troisième étape 230 du procédé 200 consiste à générer un second modèle du composant du circuit électrique de la batterie configuré pour évaluer la résistance de surface *Rsurf* de la batterie à partir de l'intensité I de courant appliqué à la batterie, de la température T de la batterie et de l'état de santé de la batterie SOH. La génération du second modèle comprend, pour chaque paramètre du premier modèle, l'intégration de la fonction caractérisant l'évolution dudit chaque paramètre en fonction d'une évolution de l'état de santé de la batterie SOH. Ainsi, dans un exemple, le second modèle électrique du procédé 200 peut se baser sur l'équation (3) précédente.

Une quatrième étape 240 du procédé 200 consiste à mesurer l'intensité I de courant appliqué à la batterie, la température T de la batterie et obtenir l'état de santé SOH de la batterie. Pour obtenir, l'état de santé SOH de la batterie, il est possible d'utiliser une technique connue de l'état de l'art.

Une cinquième étape 250 du procédé 200 consiste à déterminer de la résistance de surface R_{surf} de la batterie en fournissant au second modèle l'intensité I de courant appliqué à la batterie, la température T de la batterie et l'état de santé de la batterie SOH obtenus à l'étape 240.

Ainsi, le procédé 200, peut être utilisé pour calculer directement la résistance de surface R_{surf} de la batterie à partir d'un état de santé connu. Le procédé peut être implémenté par ordinateur ou par un processeur par exemple compris dans un système de management d'une batterie. Le procédé 200 est particulièrement intéressant car, parmi l'ensemble des paramètres du modèle électrique de la batterie, la résistance de surface R_{surf} de la batterie est celui qui évolue le plus avec le vieillissement de la batterie et qui doit être mis à jour en priorité. D'ailleurs, la mise à jour seule de ladite résistance de surface peut suffire pour une première estimation de la nouvelle impédance de la batterie.

Une sixième étape 260 optionnelle du procédé 200 consiste à modifier les conditions d'utilisation de la batterie en fonction de la résistance de surface R_{surf} de la batterie déterminée à l'étape 250, par exemple de manière similaire à l'étape 160 précédemment décrite en relation au procédé illustré sur la figure 1.

Sauf précision contraire, un même élément apparaissant sur des figures différentes présente une référence unique.

## Revendications

1. Procédé (100) de surveillance d'un état de santé SOH d'une batterie électrique, le procédé étant mis en œuvre par un système de gestion de la batterie et comprenant des étapes de :
- Obtention (110) d'un premier modèle d'un composant d'un circuit électrique de la batterie, le premier modèle comprenant quatre paramètres :
∘ la résistance de l'interphase de l'électrolyte solide à une température de 25°C *R_{SEI}*(25°*C*), exprimée en ohms noté Ω,
∘ l'énergie d'activation liée à l'interphase de l'électrolyte solide *E_{a,SEI}*, exprimée en électronvolts noté eV,
∘ l'intensité du courant d'échange de la batterie à 25°C *I*₀(25°*C*), exprimée en ampères noté A, et
∘ l'énergie d'activation liée à l'intensité du courant d'échange de la batterie à 25°C, exprimée en électronvolts noté eV, et le premier modèle étant basé sur une première équation telle que : ${R}_{surf} \left(I, T\right) = {R}_{SEI} \left(25°C\right) exp \left(\frac{{E}_{a , SEI}}{{k}_{B}}\left(\frac{1}{T}-\frac{1}{298}\right)\right) + \frac{2 RT}{FI} asinh \left(\frac{I}{2 {I}_{0} \left(25°C\right)}exp\left(\frac{{E}_{a , {I}_{0}}}{{k}_{B}}\left(\frac{1}{T}-\frac{1}{298}\right)\right)\right)$ Avec:
∘ *k_{B},* une constante de Boltzmann, exprimée en électronvolts par kelvin noté eV/K,
∘ *R*, une constante universelle des gaz parfaits, exprimée en joules par mole par kelvin noté J/(mol*K),
∘ *F*, une constante de Faraday, exprimée en coulombs par mole noté C/mol,
∘ *T*, une température de la batterie, exprimée en kelvin noté K,
∘ *I*, une intensité du courant de la cellule, exprimé en ampères noté A,
- Détermination (120), pour chaque paramètre parmi les paramètres du premier modèle, d'une fonction caractérisant l'évolution dudit chaque paramètre en fonction d'une évolution de l'état de santé de la batterie SOH,
- Génération (130) d'un second modèle du composant du circuit électrique de la batterie configuré pour évaluer l'état de santé de la batterie SOH à partir de la résistance de surface Rsurf de la batterie, de l'intensité I de courant appliqué à la batterie et de la température T de la batterie, la génération du second modèle comprenant, pour chaque paramètre du premier modèle, l'intégration de la fonction caractérisant l'évolution dudit chaque paramètre en fonction d'une évolution de l'état de santé de la batterie SOH permettant d'obtenir une seconde équation telle que : $\begin{matrix}{R}_{surf} \left(I, T, SOH\right) = {R}_{SEI , neuf} \left(25°C\right) \left[{α}_{{R}_{SEI}}\left(SOH-1\right)+1\right] \times exp \left(\frac{{E}_{a , SEI}}{{k}_{B}}\left(\frac{1}{T}-\frac{1}{298}\right)\right) \\ + \frac{2 RT}{FI} asinh \left(\frac{I}{2 {I}_{0 , neuf} \left(25°C\right)}\left[\begin{matrix}{α}_{{R}_{ct}} \left(SOH-1\right) \\ + 1\end{matrix}\right]exp\left(\frac{{E}_{a , {I}_{0} , neuf} \left[{α}_{{E}_{a , {I}_{0}}}\left(SOH-1\right)+1\right]}{{k}_{B}}\left(\frac{1}{T}-\frac{1}{298}\right)\right)\right)\end{matrix}$
- Mesure (140) de l'intensité I de courant appliqué à la batterie, de la température T de la batterie et obtention de la résistance de surface Rsurf de la batterie, et
- Détermination (150) de l'état de santé de la batterie SOH en fournissant au second modèle l'intensité I de courant appliqué à la batterie, la température T de la batterie et la résistance de surface Rsurf de la batterie obtenus (140).

2. Procédé (100) selon la revendication 1, comprenant en outre une modification (160) des conditions d'utilisation de la batterie en fonction de l'état de santé SOH déterminé (150).

3. Procédé (100) selon la revendication 2 dans lequel la modification (160) des conditions d'utilisation de la batterie comprend :
- Lorsque l'état de santé SOH déterminé (150) est inférieur à une valeur seuil d'état de santé prédéterminée, remplacer la batterie par une nouvelle batterie, et/ou
- Interrompre une utilisation de la batterie en cas d'atteinte d'une température maximale, la température maximale étant déterminée à partir de l'état de santé SOH déterminé (150), et/ou
- Charger la batterie à une intensité de courant inférieure ou égale à une intensité de courant maximale, l'intensité de courant maximale étant déterminée à partir de l'état de santé SOH déterminé (150).

4. Procédé (100) selon l'une quelconque des revendications 1 à 3, dans lequel la détermination (120), pour chaque paramètre parmi les paramètres du premier modèle, d'une fonction caractérisant l'évolution dudit chaque paramètre en fonction d'une évolution de l'état de santé de la batterie SOH comprend :
- un premier essai de spectroscopie d'impédance électrochimique consistant à appliquer à la batterie une onde de courant sinusoïdale avec une valeur moyenne nulle à la batterie et à mesurer une variation de tension de la batterie, et/ou
- un second essai d'impulsions de courant consistant à appliquer à la batterie des impulsions de courant en charge et en décharge.

5. Procédé (100) selon l'une quelconque des revendications 1 à 4, dans lequel la génération (130) du second modèle du composant du circuit électrique de la batterie comprend une détermination de la seconde équation et :
- Une résolution de la seconde équation, pour un ensemble de valeurs de SOH, permettant d'évaluer l'état de santé SOH à partir de la résistance de surface Rsurf de la batterie, et/ou
- Une génération d'une table des paramètres permettant d'évaluer directement l'état de santé SOH à partir de l'intensité I de courant appliqué à la batterie, de la température T de la batterie et de la résistance de surface Rsurf de la batterie.

6. Système de gestion d'une batterie électrique comprenant des moyens de mise en œuvre du procédé selon l'une quelconque des revendications 1 à 5.

7. Aéronef comprenant une batterie électrique et un système de gestion de la batterie selon la revendication 6.

8. Programme d'ordinateur comprenant des instructions qui, lorsque le programme est exécuté par le système de gestion d'une batterie électrique selon la revendication 6, conduisent celui-ci à mettre en œuvre un procédé selon l'une quelconque des revendications 1 à 5.

9. Support de données lisible par ordinateur, sur lequel est enregistré le programme d'ordinateur selon la revendication 8.

## Patentansprüche

1. Verfahren (100) zur Überwachung des Gesundheitszustands (SOH) einer elektrischen Batterie, wobei das Verfahren von einem Batteriemanagementsystem durchgeführt wird und folgende Schritte umfasst:
- Ermitteln (110) eines ersten Modells einer Komponente eines elektrischen Schaltkreises der Batterie, wobei das erste Modell vier Parameter umfasst:
∘ den Widerstand der Grenzfläche des Festelektrolyten bei einer Temperatur von 25 °C R_{SEI} (25 °C), ausgedrückt in Ohm, bezeichnet mit Ω,
∘ die mit der Grenzfläche des Festelektrolyten verbundene Aktivierungsenergie Eₐ,_{SEI}, ausgedrückt in Elektronenvolt, bezeichnet mit eV,
∘ die Austauschstromstärke der Batterie bei 25 °C I₀ (25 °C), ausgedrückt in Ampere, abgekürzt A, und
∘ die Aktivierungsenergie in Abhängigkeit von der Austauschstromstärke der Batterie bei 25 °C, ausgedrückt in Elektronenvolt (eV), und
- wobei das erste Modell auf einer ersten Gleichung basiert, die wie folgt lautet: ${R}_{surf} \left(I, T\right) = {R}_{SEI} \left(25°C\right) exp \left(\frac{{E}_{a , SEI}}{{k}_{B}}\left(\frac{1}{T}-\frac{1}{298}\right)\right) + \frac{2 RT}{FI} asinh \left(\frac{I}{2 {I}_{0} \left(25°C\right)}exp\left(\frac{{E}_{a , {I}_{0}}}{{k}_{B}}\left(\frac{1}{T}-\frac{1}{298}\right)\right)\right)$ Dabei gilt:
∘ *k_{B}* die Boltzmann-Konstante, ausgedrückt in Elektronenvolt pro Kelvin, abgekürzt eV/K,
∘ Rdie universelle Gaskonstante, ausgedrückt in Joule pro Mol pro Kelvin, abgekürzt J/(mol·K),
∘ *F* die Faraday-Konstante, ausgedrückt in Coulomb pro Mol, abgekürzt C/mol,
∘ Tdie Temperatur der Batterie, ausgedrückt in Kelvin (K),
∘ *I* die Stromstärke der Zelle, ausgedrückt in Ampere, abgekürzt A,
- Bestimmung (120) für jeden der Parameter des ersten Modells einer Funktion, die die Entwicklung des jeweiligen Parameters in Abhängigkeit von der Entwicklung des Batteriezustands (SOH) charakterisiert,
- Erstellen (130) eines zweiten Modells der elektrischen Schaltungskomponente der Batterie, das so gestaltet ist, dass es anhand des Oberflächenwiderstands Rsurf der Batterie, der an der Batterie angelegten Stromstärke I und der Temperatur T der Batterie den Batteriezustand (SOH) bewertet, wobei das Erstellen des zweiten Modells für jeden Parameter des ersten Modells die Integration der Funktion umfasst, die den Verlauf jedes dieser Parameter in Abhängigkeit von einer Veränderung des Batteriezustands (SOH) charakterisiert, wodurch eine zweite Gleichung wie die folgende erhalten wird: $\begin{matrix}{R}_{surf} \left(I, T, SOH\right) = {R}_{SEI , neuf} \left(25°C\right) \left[{α}_{{R}_{SEI}}\left(SOH-1\right)+1\right] \times exp \left(\frac{{E}_{a , SEI}}{{k}_{B}}\left(\frac{1}{T}-\frac{1}{298}\right)\right) \\ + \frac{2 RT}{FI} asinh \left(\frac{I}{2 {I}_{0 , neuf} \left(25°C\right)}\left[\begin{matrix}{α}_{{R}_{ct}} \left(SOH-1\right) \\ + 1\end{matrix}\right]exp\left(\frac{{E}_{a , {I}_{0} , neuf} \left[{α}_{{E}_{a , {I}_{0}}}\left(SOH-1\right)+1\right]}{{k}_{B}}\left(\frac{1}{T}-\frac{1}{298}\right)\right)\right)\end{matrix}$
- Messung (140) der an der Batterie angelegten Stromstärke I, der Batterietemperatur T und Ermittlung des Oberflächenwiderstands Rsurf der Batterie sowie
- Bestimmung (150) des Batteriezustands SOH durch Eingabe der an der Batterie angelegten Stromstärke I, der Batterietemperatur T und des ermittelten Oberflächenwiderstands Rsurf der Batterie (140) in das zweite Modell.

2. Verfahren (100) nach Anspruch 1, das ferner eine Anpassung (160) der Nutzungsbedingungen der Batterie in Abhängigkeit vom ermittelten Gesundheitszustand SOH (150) umfasst.

3. Verfahren (100) nach Anspruch 2, bei dem die Anpassung (160) der Nutzungsbedingungen der Batterie Folgendes umfasst:
- Wenn der ermittelte SOH-Zustand (150) unter einem vorgegebenen SOH-Schwellenwert liegt, die Batterie durch eine neue Batterie zu ersetzen und/oder
- Unterbrechung der Nutzung der Batterie bei Erreichen einer Maximaltemperatur, wobei die Maximaltemperatur anhand des ermittelten SOH-Zustands (150) bestimmt wird, und/oder
- die Batterie mit einer Stromstärke aufladen, die kleiner oder gleich einer maximalen Stromstärke ist, wobei die maximale Stromstärke anhand des ermittelten SOH-Zustands (150) bestimmt wird.

4. Verfahren (100) nach einem der Ansprüche 1 bis 3, bei dem die Bestimmung (120) einer Funktion für jeden der Parameter des ersten Modells, die den Verlauf des jeweiligen Parameters in Abhängigkeit von einer Veränderung des Batteriezustands SOH charakterisiert, Folgendes umfasst:
- einen ersten elektrochemischen Impedanzspektroskopie-Test, der darin besteht, an der Batterie eine sinusförmige Stromwelle mit einem Mittelwert von Null anzulegen und eine Spannungsänderung der Batterie zu messen, und/oder
- einen zweiten Stromimpulstest, der darin besteht, an der Batterie Stromimpulse beim Laden und Entladen anzulegen.

5. Verfahren (100) nach einem der Ansprüche 1 bis 4, bei dem die Erzeugung (130) des zweiten Modells der elektrischen Schaltungskomponente der Batterie eine Bestimmung der zweiten Gleichung und Folgendes umfasst:
- eine Lösung der zweiten Gleichung für eine Reihe von SOH-Werten, wodurch der SOH-Zustand anhand des Oberflächenwiderstands Rsurf der Batterie bewertet werden kann, und/oder
- eine Erstellung einer Parametertabelle, die es ermöglicht, den SOH-Zustand direkt anhand der an der Batterie angelegten Stromstärke I, der Batterietemperatur T und des Oberflächenwiderstands Rsurf der Batterie zu bewerten.

6. Managementsystem für eine elektrische Batterie, das Mittel zur Durchführung des Verfahrens nach einem der Ansprüche 1 bis 5 umfasst.

7. Luftfahrzeug mit einer elektrischen Batterie und einem Batteriemanagementsystem nach Anspruch 6.

8. Computerprogramm, das Befehle umfasst, die, wenn das Programm von dem Batteriemanagementsystem nach Anspruch 6 ausgeführt wird, dieses dazu veranlassen, ein Verfahren nach einem der Ansprüche 1 bis 5 durchzuführen.

9. Computerlesbarer Datenträger, auf dem das Computerprogramm nach Anspruch 8 gespeichert ist.

## Claims

1. Method (100) for monitoring a state of health SOH of an electric battery, comprising the steps of:
- Obtaining (110) a first model of a component of an electrical circuit of the battery, the first model comprising four parameters:
∘ the resistance of the interphase of the solid electrolyte at a temperature of 25°C *R_{SEI}*(25°*C*), expressed in ohms, denoted Ω,
∘ the activation energy related to the interphase of the solid electrolyte *E_{a,SEI}*, expressed in electronvolts, denoted eV,
othe intensity of the battery exchange current at 25°C *I*₀(25°*C*),expressed in amperes, denoted A, and
∘ the activation energy related to the intensity of the battery exchange current at 25°C, expressed in electronvolts denoted eV, and
the first model being based on a first equation such as: ${R}_{surf} \left(I, T\right) = {R}_{SEI} \left(25°C\right) exp \left(\frac{{E}_{a , SEI}}{{k}_{B}}\left(\frac{1}{T}-\frac{1}{298}\right)\right) + \frac{2 RT}{FI} asinh \left(\frac{I}{2 {I}_{0} \left(25°C\right)}exp\left(\frac{{E}_{a , {I}_{0}}}{{k}_{B}}\left(\frac{1}{T}-\frac{1}{298}\right)\right)\right)$ With:
∘ *k_{B},* a Boltzmann constant, expressed in electronvolts per kelvin, denoted eV/K,
oR, a universal ideal gas constant, expressed in joules per mole per kelvin, denoted J/(mol*K),
oF, a Faraday constant, expressed in coulombs per mole, denoted C/mol,
∘ *T*, the battery temperature, expressed in kelvin denoted K,
∘ *I*, the intensity of the cell current, expressed in amperes, denoted A,
- Determination (120), for each parameter among the parameters of the first model, of a function characterizing the evolution of said each parameter as a function of an evolution of the state of health SOH of the battery,
- Generation (130) of a second model of the battery's electrical circuit component configured to evaluate the state of health SOH of the battery from the surface resistance Rsurf of the battery, the current intensity I applied to the battery and the temperature T of the battery, the generation of the second model comprising, for each parameter of the first model, the integration of the function characterizing the evolution of said each parameter as a function of an evolution of the state of health SOH of the battery allowing to obtain a second equation such as: $\begin{matrix}{R}_{surf} \left(I, T, SOH\right) = {R}_{SEI , neuf} \left(25°C\right) \left[{α}_{{R}_{SEI}}\left(SOH-1\right)+1\right] \times exp \left(\frac{{E}_{a , SEI}}{{k}_{B}}\left(\frac{1}{T}-\frac{1}{298}\right)\right) \\ + \frac{2 RT}{FI} asinh \left(\frac{I}{2 {I}_{0 , neuf} \left(25°C\right)}\left[\begin{matrix}{α}_{{R}_{ct}} \left(SOH-1\right) \\ + 1\end{matrix}\right]exp\left(\frac{{E}_{a , {I}_{0} , neuf} \left[{α}_{{E}_{a , {I}_{0}}}\left(SOH-1\right)+1\right]}{{k}_{B}}\left(\frac{1}{T}-\frac{1}{298}\right)\right)\right)\end{matrix}$
- Measurement (140) of the current intensity I applied to the battery, the temperature T of the battery and obtaining the surface resistance Rsurf of the battery, and
- Determination (150) of the state of health SOH of the battery by providing the second model with the current intensity I applied to the battery, the temperature T of the battery and the surface resistance Rsurf of the battery obtained (140).

2. Method (100) according to claim 1, further comprising a modification (160) of the battery usage conditions according to the determined state of health SOH (150).

3. Method (100) according to claim 2 wherein the modification (160) of the battery operating conditions comprises:
- When the determined state of health SOH (150) is below a predetermined state of health threshold value, replace the battery with a new one, and/or
- Discontinue battery use if a maximum temperature is reached, the maximum temperature being determined from the determined state of health SOH (150), and/or
- Charge the battery at a current intensity less than or equal to a maximum current intensity, the maximum current intensity being determined from the determined state of health SOH (150).

4. A method (100) to any of claims 1 to 3, wherein the determination (120), for each parameter among the parameters of the first model, of a function characterizing the evolution of said each parameter as a function of an evolution of the state of health SOH of the battery comprises:
- a first electrochemical impedance spectroscopy test consisting of applying a sinusoidal current wave with a zero average value to the battery and measuring a change in battery voltage, and/or
- a second current pulse test consisting of applying current pulses to the battery during charging and discharging.

5. Method (100) according to any of claims 1 to 4, wherein the generation (130) of the second model of the battery electrical circuit component comprises a determination of the second equation and:
- A solution to the second equation, for a set of state of health SOH values, allowing the state of health SOH to be assessed from the surface resistance Rsurf of the battery, and/or
- A generation of a parameter table allowing direct evaluation of the state of health SOH from the current intensity I applied to the battery, the temperature T of the battery and the surface resistance Rsurf of the battery.

6. An electric battery management system comprising means for implementing the method according to any of claims 1 to 5.

7. Aircraft comprising an electric battery and a battery management system according to the claim 6.

8. Computer program comprising instructions which, when the program is executed by the management system of an electric battery according to claim 6, cause the latter to implement a method according to any one of claims 1 to 5.

9. Computer-readable data carrier on which the computer program according to claim 8 is stored.
